Europäisches Patentamt

European Patent Office

Office européen des brevets

(11) Publication number: **0 328 746**
**A2**

## EUROPEAN PATENT APPLICATION

(21) Application number: 88118976.5

(22) Date of filing: 14.11.88

(51) Int. Cl.⁴: **H01L 21/00 , D06B 5/12 , B08B 11/00**

(30) Priority: 18.02.88 JP 33941/88

(43) Date of publication of application:
23.08.89 Bulletin 89/34

(84) Designated Contracting States:
CH DE FR GB IT LI

(71) Applicant: SONIC FELLOW KABUSHIKI KAISHA
1-46-17, Yokoyamadai
Sagamihara Kanagawa-ken(JP)

(72) Inventor: Usui, Toru c/o Sonic Fellow Kabushiki Kaisha
1-46-17, Yokoyamadai
Sagamihara Kanagawa-ken(JP)

(74) Representative: Bühling, Gerhard, Dipl.-Chem. et al
Patentanwaltsbüro Tiedtke-Bühling-Kinne Grupe-Pellmann-Grams-Struif-Winter-Roth
Bavariaring 4
D-8000 München 2(DE)

(54) Drying method for precision washing.

(57) A drying method for precision washing performed is disclosed in which a drying gas is used to remove the water from the surfaces of an object to be washed after precision washing of said object at a preceding stage and final washing with pure water, wherein said object immersed in said pure water serving as washing water is pulled up out the water surface at a given speed into said drying gas.

*F I G. 1*

EP 0 328 746 A2

## Drying Method for Precision Washing

(Field of the Invention)

The technology disclosed relates to the technical field of ultra-precision washing of electronic parts such as wafers and parts such as optical lenses and glass.

## Description of the Prior Art

As is generally known, recent daily life and industrial society owe much to precision science and technology, and particularly to machines and optical devices employing electronic devices and electronic controls. Therefore, an extremely severe degree of precision of such electronic and optical devices has been demanded. So-called IC parts and electronic optical parts are not permitted to have dust adhering to the surfaces of products because of their precision and are required to have a degree of precision in the order of one micron. Thus, the ultra-precision washing of a submicron order above the precision washing of a micron order is required in the process of manufacturing this sort of precision part. It is necessary for the process of manufacturing parts to include a process in which a work piece that is produced in the preceding production process and that is an object to be washed is subjected to washing with chemicals and the application of ultrasonic waves in the final process of washing to complete the product.

However, in a conventional washing process, an object to be washed is immersed in a pure water washing tank so as to be finally washed with pure water after a precise washing process comprising a plurality of stages, then pulled up out of the pure water after the final washing, and dried by blowing a drying gas such as air or nitrogen gas in a portion above the object onto the surfaces thereof having pure water adhering thereto.

However, it is substantially impossible from both the theoretical and the actual viewpoints that the pure water in the pure water washing tank and the drying gas be 100% pure, and dust particles of submicron order and residual chemicals such as the washing chemicals used in the preceding process are still present in trace amounts. There is therefore the problem that, if the pure water adheres to the washed surfaces during the process of pulling up the object immersed in the pure water in the final washing process into the drying gas to dry the object, the dust and the chemicals contained in the pure water and concentrated during the drying process employing blowing of the drying gas remain as so-called stains on the washed surfaces of the object and make it impossible to meet the requirement of ultra-precision washing of a submicron order.

A problem to be solved by the invention is the problem of ultra-precision washing at the final washing stage of a process of manufacturing electronic devices and optical products on the basis of the above-described prior art. It is an object of the present invention to provide an excellent drying method for precision washing by which substantially complete prevention of adhesion of dust,which produces stains on washed surfaces during the process of pulling on object to be washed from the pure water in a pure water washing tank,can be achieved by employing theoretical analyses of the results of experiments and tests. This brings advantage to those fields employing a washing technology in industries that produce ultra-precision parts.

## Summary of the Invention

Accordingly, the present invention is an invention relating to a drying method for precision washing in which an object to be washed that is carried from a production process in a preceding process is subjected to precision washing using chemicals and ultrasonic waves at a plurality of stages of a given number, then finally washed with pure water in a pure water tank and is then pulled from the pure water in the pure water tank into a drying gas so that the pure water adhering to the washed surfaces is removed. In particular, the present invention is an invention relating to a drying method for precision washing in which an object to be washed that is immersed in the pure water in the pure water tank for the purpose of final washing is pulled up from the water surface of the pure water into a drying gas at a given speed such as an ultra-low speed, so that the object can instantaneously be dried in the process of pulling up.

(Background of the Invention)

It was found from repeated experiments and tests conducted by the applicant who is skilled in the art that, if the pure water adhering to the washed surfaces of an object to be washed immersed in the pure water used in the final washing has the form of a spot or block, i.e. the form of a waterdrop, of various sizes, the adhesion of dust particles and the chemicals used in the preceding stage takes place owing to concentration during the drying process, while, if the pure water adhering to the washed surfaces has the form of a thin film extending over a wide range, the adhesion of dust particles and chemicals is not much produced by concentration during drying with a drying gas.

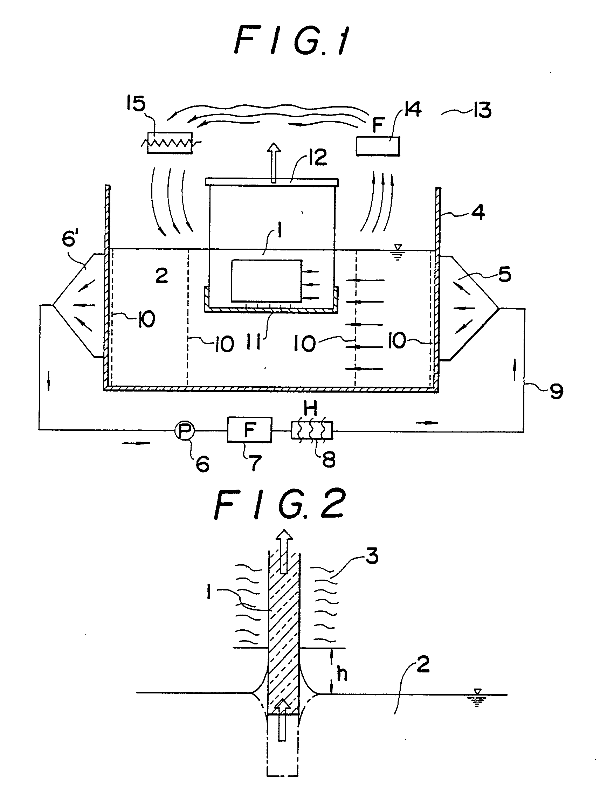

On the basis of the data and results of the experiments and tests, it was found that, as shown in Fig. 2 (the aspect of a hydrophilic body is shown by the solid lines in Fig. 2 and the aspect of a hydrophobic body is reversed as shown by the dotted lines), for example, when a glass plate 1 of an optical part serving as a precision part is immersed in a washing tank 2 in a final washing tank (not shown in the drawing) and then pulled up at a ultra-low speed that approximates zero as much as possible, in the process of pulling up the glass plate into a drying gas 3 in an upper portion, the pure water 2 which adheres to the washed surfaces of the object 1 in the form of a film with a height h determined by the balance of the cohesive force and surface tension of the pure water 2,is connected to the drying gas 3 in the upper portion and does not rise from the given height h as the object 1 is pulled up at the ultra-low speed in the direction shown by the arrow. It was therefore found that pulling-up of the object 1 at the ultra-low speed causes the pure water 2 adhering in the form of a film to be immediately brought into contact with the drying gas above the height h of the pure water 2, and drying is performed at the upper end of the adhering pure water 2 quickly as compared with the ultra-low speed of the pulling up of the object 1 so that no stain is formed from adhesion of dust particles and residual chemicals used in the preceding stage through concentration, whereby the object 1 having the washed surfaces which have no stain and are subjected to ultra-precision drying of the submicron order can be obtained.

It was also found that, as described above, the film portion of water widely adhering to the washed surfaces of the object 1 in the form of a film having the height h does not adhere in the form of a film to the surfaces above the height h due to the cohesive force and surface tension of the pure water, and the end of the pure water film is immediately brought into contact with the drying gas in the portion near the top of the height h so that drying is quickly performed.

It is possible to obtain from this theory the theoretical analysis that no adhesion of pure water in the form of a spot or a block, i.e. a waterdrop, takes place in the portion above the height h of the adhering pure water and no stain is thus produced.

Therefore, it is preferable to provide the pure water with a laminar flow in the lateral direction during the process of pulling up the object 1 from the pure water 2.

Brief Description of the Drawings

Fig. 1 is a longitudinal section of an embodiment of the present invention; and

Fig. 2 is a section of the fundamental aspect of the present invention.

## Detailed Description of the Preferred Embodiment

An embodiment of the present invention is described below with reference to Figs. 1 and 2.

In the embodiment shown in the drawings, reference numeral 4 denotes a pure water washing tank for final washing which is connected to the final stage of the precision washing tanks in the preceding process comprising a given plurality of stages. Storage tanks 5, 5' used for circulating the pure water 2 are provided on the front and rear sides of the washing tank 4 and are connected through a circulating circuit 9 having a circulating pump 6, a filter 7 and a heater for heating to a given temperature. Perforated plates 10, 10 ... in which many fine pores each having a give size are formed are provided upright in the vertical direction inside the tank body and on the two sides thereof so that the pure water 2 is caused to flow in a laminar form from the storage tank 5 to the storage tank 5' in the lateral direction at a given low speed that is uniform in the vertical positions. The pure water is heated to a given temperature by the heater 8 in the circulating process outside the tank body 4, as well as dust particles of the submicron order being completely removed by the filter 7.

A holder 11 used for transferring the object 1 from the preceding stage and for immersing the object 1 (arranged in a given number in parallel from the front side to the back of the tank shown in Fig. 1) in the pure water 2 is provided in the tank body in such a manner that it can be immersed in the pure water and pulled therefrom by means of a suitable elevator 12. A circulating fan 14 which circulates the drying gas 3 such as air at a given low speed in a chamber 13 and which contains a submicron capture filter and a heater 15 for heating the drying gas 3 to a given temperature,are respectively provided in given positions in the chamber 13 above the surface of the pure water 2.

Therefore, when the object 1 which is produced in the preceding process and subjected to precision washing with given washing solutions and ultrasonic waves at a given number of stages is finally washed in the pure water washing tank 4, the pure water 2 which has been previously passed through the circulating circuit 9 having the circulating pump 6, the filter 7 and the heater 8 so that dust particles of the submicron order have been removed and the pure water 2 was heated to a given temperature,is caused to flow in a laminar form from the storage tank 5' through the perforated plates 10, 10 ... in the lateral direction in such a manner that the speeds in the vertical positions are uniform. In addition, the air serving as the drying gas 3 above the tank 4 is circulated by the circulating fan 14 and the heater 15 at a given low speed in the chamber 13 while dust particles of the submicron order are being captured and removed.

Then, the object 1 which is transferred by the holder 11 from the precision washing at the preceding stage, is immersed in the pure water 2 in the pure water washing tank 4 and, after a given time has passed, pulled out from the surface of the pure water 2 into the drying gas 3 at a speed that approximates zero as much as possible by means of the elevator 12.

Although the pure water 2 adheres to the washed surfaces of the object 1 in the form of a film having a given height h during the process of pulling out in accordance with the aforementioned fundamental aspect, the pure water 2 does not additionally rise above the top of the height h. Thus, the pure water 2 is brought into contact with the drying gas 3, and drying is instantaneously performed of the pure water 2 in the form of a thin film, as compared with the ultra-low speed of the rising of the object 1. Consequently, as described above, no concentration of waterdrops such as spots or blocks takes place, and no stain is thus produced on the washed surfaces, without the drying gas 3 being disturbed by blowing, whereby ultra-precision drying in accordance with the design can be achieved.

The repetition of such a drying work enables drying with a high degree of precision.

When the laminar flow in the lateral direction is provided to the pure water 2 in the pure water washing tank 4 during the elevation of the object 1 in the pure water 2, as described above, the laminar flows at the same speed in vertical positions can be obtained, without producing any sedimentation of dust particles and chemicals mixed in the pure water in the preceding stage. Since the upward flow of the drying gas 3 formed by the circulating fan 4 is changed to a laminar flow in the lateral direction, dust particles of the submicron order, which are unexpectedly mixed in, can be removed by filtration in the filter contained in the circulating fan 14.

As a matter of course, an embodiment of the present invention is not limited to the above-described embodiment. For example, various forms such as one which can be applied to the preceding process of precision washing with chemicals can be employed.

As described above, in accordance with the present invention, in the process of pulling an object to be washed from pure water after the object has been washed by being immersed in the pure water in a pure water washing tank in the final washing after precision washing in the process of finishing ultra-precision parts such as electronic parts and optical parts, the speed of pulling up from the pure water is made super low so that the pure water is raised while adhering to the washed surfaces of the object in the form of a film having a given height determined by the balance of the cohesive force and surface tension of the pure water but is not raised above the height h. Therefore, no adhesion of the pure water in the form of a waterdrop such as a spot or a block takes place, and thus no concentration of dust particles of the submicron order and chemicals used in the preceding stage, which are mixed in the pure water, takes place, resulting in the excellent effect that the entire washing surfaces can be washed and dried with an extremely high degree of precision.

Since the pure water used for final washing is circulated in the form of a laminar flow in the lateral direction in the washing tank, there is the effect that dust particles which are unexpectedly mixed in the washing tank do not stay therein and are completely captured and removed by filtration in the circulating process.

In addition, since the drying gas is subjected to precision filtration, there is the excellent effect that no dust particles of the submicron order unexpectedly mixed in the pure water adhere to the washed surfaces in the process of pulling the object from the pure water at an ultra-low speed.

A laminar flow in the lateral direction was previously provided to the pure water in a pure water washing tank when an object to be washed is finally washed with pure water in the pure water washing tank after the precision washing at a plurality of stages of a given number has been completed at the preceding stage in the washing process subsequent to a process of manufacturing ultra-precision parts of electronic devices, optical products and the like so that the pure water is circulated while the dust in the pure water and the residual chemicals used in the preceding stage are caught by filtration. A drying gas in an upper portion is also circulated in the lateral direction and downward direction so that dust particles down to a submicron size are captured in a filter by filtration. Therefore, when the object to be washed is immersed in the pure water and then pulled up out of the pure water in the pure water washing tank into the drying gas above the object, the object is pulled out at a given speed, e.g. at as ultra-low a speed as possible, so that the pure water adheres to the washed surfaces of the object in the form of a thin film only as high as permitted by the cohesive force and surface tension of the pure water. Although the pure water adhering in the form of a thin film to the washed surfaces adheres up to that height, drying is performed at the upper end of the thin film quickly as compared with the ultra-low speed of pulling the object out,because the pure water at the upper end is immediately brought into contact with the drying gas. Consequently, no stain is produced on the washed surfaces by the concentration of dust and the chemicals used in the preceding stage whereby products having washed surfaces which are subjected to ultra-precision washing and drying can be obtained.

A drying method for precision washing performed is disclosed in which a drying gas is used to remove the water from the surfaces of an object to be washed after precision washing of said object at a preceding stage and final washing with pure water, wherein said object immersed in said pure water serving as washing water is pulled up out the water surface at a given speed into said drying gas.

## Claims

(1) A drying method for precision washing performed in which a drying gas is used to remove the water from the surfaces of an object to be washed after precision washing of said object at a preceding stage and final washing with pure water, wherein said object immersed in said pure water serving as washing water is pulled up out of the water surface at a given speed into said drying gas.

(2) A drying method for precision washing according to Claim 1, wherein said pure water is formed into a laminar flow flowing in the lateral direction in a washing tank.

(3) A drying method for precision washing according to Claim 1, wherein said drying gas was previously subjected to ultra-precision filtration.

# F I G. 1

# F I G. 2